# EUROPEAN PATENT APPLICATION

(11) **EP 4 845 336 A1**
(43) Date of publication of application: **25.11.2026**
(21) Application number: 24921840.5
(22) Date of filing: 31.12.2024
(51) Int. Cl.: H10D 30/60, H01L 23/31, H10D 48/00, H10D 62/10

(54) **SEMICONDUCTOR DEVICE AND MANUFACTURING METHOD THEREFOR, CHIP, ELECTRONIC DEVICE, AND VEHICLE**

(30) Priority: 01.02.2024 CN 202410144770
(71) Applicant: Huawei Technologies Co., Ltd., Shenzhen, Guangdong 518129 (CN)
(72) Inventor: HU, Fei, Shenzhen, Guangdong 518129 (CN); TANG, Longgu, Shenzhen, Guangdong 518129 (CN); ZHENG, Yaliang, Shenzhen, Guangdong 518129 (CN); GUO, Zhiyu, Shenzhen, Guangdong 518129 (CN); PENG, Yingchun, Shenzhen, Guangdong 518129 (CN); YIN, Binfeng, Shenzhen, Guangdong 518129 (CN); NING, Runtao, Shenzhen, Guangdong 518129 (CN); TANG, Cen, Shenzhen, Guangdong 518129 (CN)
(74) Representative: Maiwald GmbH
(86) International application number: PCT/CN2024/144509
(87) International publication number: WO 2025/161818

(57) **Abstract**

This application provides a semiconductor device and a manufacturing method thereof, a chip, an electronic device, and a vehicle. The semiconductor device includes: a substrate; a dielectric layer, where the dielectric layer is disposed on the substrate; a first passivation layer, where the first passivation layer is disposed on a side that is of the dielectric layer and that faces away from the substrate; and a first conductive layer, where the first conductive layer and the first passivation layer are disposed on a same side of the substrate, and a part of the first conductive layer is stacked on the side that is of the dielectric layer and that faces away from the substrate; and a first spacing exists between the first conductive layer and the first passivation layer in a first direction, where the first direction is perpendicular to a thickness direction of the semiconductor device. This application can reduce cracking of the semiconductor device.

## Description

### TECHNICAL FIELD

This application relates to the field of semiconductor technologies, and in particular, to a semiconductor device and a manufacturing method thereof, a chip, an electronic device, and a vehicle.

### BACKGROUND

In power factor correction (power factor correction, PFC) rectifiers, inverters, on-board electric drive microcontroller units (microcontroller units, MCUs), and on-board battery chargers (on-board battery chargers, OBCs), semiconductor devices such as transistors are usually provided. A transistor may include a substrate, a conductive layer and a passivation layer disposed on the substrate, and the like. After packaging of the transistor is completed, reliability tests such as temperature cycle and temperature shock tests need to be performed. During the tests, shear stress is generated due to a mismatch among coefficients of thermal expansion (coefficients of thermal expansion, CTEs) of the substrate, the conductive layer, and the passivation layer. Because the passivation layer is made of a relatively rigid material, the shear stress causes a crack inside the passivation layer, resulting in cracking of the passivation layer and a failure of the transistor.

### SUMMARY

To resolve the foregoing technical problem, this application provides a semiconductor device and a manufacturing method thereof, a chip, an electronic device, and a vehicle, to reduce cracking of the semiconductor device.

According to a first aspect of this application, a semiconductor device is provided, and the semiconductor device may be a transistor. The semiconductor device includes a substrate, a dielectric layer, a first passivation layer, and a first conductive layer. The dielectric layer is disposed on the substrate, and the first passivation layer is disposed on a side that is of the dielectric layer and that faces away from the substrate. The first conductive layer and the first passivation layer are disposed on a same side of the substrate, and a part of the first conductive layer is stacked on the side that is of the dielectric layer and that faces away from the substrate. A first spacing exists between the first conductive layer and the first passivation layer in a first direction, the first direction is perpendicular to a thickness direction of the semiconductor device, and the first direction may be a length direction or a width direction of the semiconductor device. In other words, the first spacing exists between the first conductive layer and the first passivation layer in the length direction or the width direction of the semiconductor device. In this way, during tests such as a temperature cycle test and a temperature shock test of the semiconductor device, the substrate, the first passivation layer, and the first conductive layer may deform differently due to their different CTEs. Because the first spacing exists between the first conductive layer and the first passivation layer, the first passivation layer and the first conductive layer may deform into the first spacing after being heated. Compared with the related technology in which shear stress is generated at a position in which the first passivation layer is in contact with a corner of the first conductive layer because the first conductive layer is in direct contact with the first passivation layer and the first passivation layer covers a top surface and a side surface of the first conductive layer, the technical solution of this application can reduce generation of the shear stress, and reduce a failure, caused by cracking of the first passivation layer, of a semiconductor device, and therefore, can improve reliability of the semiconductor device.

In some implementations, the semiconductor device further includes a second passivation layer, the second passivation layer covers the side surface of the first conductive layer, and a second spacing exists between the second passivation layer and the first passivation layer in the first direction. In a process of manufacturing the semiconductor device, the dielectric layer and the first conductive layer may be first formed on the substrate, then passivation layers are formed on the first conductive layer and the dielectric layer in a deposition manner, and a passivation layer located on the top surface of the first conductive layer and a passivation layer within a specific distance from the side surface of the first conductive layer are etched away, to form the first passivation layer. Because the side surface of the first conductive layer is an inclined surface, a size of the passivation layer covering the side surface of the first conductive layer is large in the thickness direction, and the passivation layer covering the side surface of the first conductive layer cannot be completely etched away within same duration in which the passivation layer covering the top surface of the first conductive layer can be etched, a remaining passivation layer that is left on the side surface of the first conductive layer and that is obtained after etching is the second passivation layer. Therefore, the etching duration can be shortened, and costs can be reduced. Because the second passivation layer covers only the side surface of the first conductive layer, and does not cover both the top surface and the side surface of the first conductive layer and a corner therebetween, generation of shear stress in the second passivation layer can be reduced.

Based on this, the semiconductor device further includes a protective layer, a part of the protective layer covers the first conductive layer, the second passivation layer, and the first passivation layer, and a part of the protective layer is located in a fourth spacing. It may be understood that, in the process of manufacturing the semiconductor device, after the protective layer is formed, when the semiconductor device needs to be packaged, that is, a plastic packaging material needs to be formed on an outer side of the protective layer. To alleviate extrusion generated by the plastic packaging material in a packaging process, the protective layer is typically made of a material having high flexibility and elasticity. When manufacturing of the semiconductor device is completed and a reliability test is performed, because the part of the protective layer is located in the fourth spacing between the second passivation layer and the first passivation layer, the protective layer is subject to shear stress. Because the protective layer has high flexibility and elasticity, the protective layer can buffer the shear stress, thereby reducing the semiconductor device failure caused by cracking of the first passivation layer.

In addition, the semiconductor device further includes a second conductive layer, where a first part of the second conductive layer is located between the first conductive layer and the substrate, and a second part of the second conductive layer is located between the first conductive layer and the dielectric layer. In other words, the first conductive layer is located on a side that is of the second conductive layer and that faces away from the substrate, and the first conductive layer may serve as one electrode of the semiconductor device. A thickness of the second conductive layer is less than a thickness of the first conductive layer. Therefore, the first conductive layer may also be referred to as a thick metal layer, and the second conductive layer may also be referred to as a thin metal layer. An overlapping region between the second conductive layer and the dielectric layer is greater than an overlapping region between the first conductive layer and the dielectric layer. In this way, the overlapping region between the second conductive layer and the dielectric layer is larger, in other words, an overlapping region between the thin metal layer and the dielectric layer is larger, so that moisture can be better prevented from intruding into the substrate from the second conductive layer and the dielectric layer, that is, the semiconductor device has a better moisture resistance capability. In addition, the overlapping region between the first conductive layer and the dielectric layer is smaller, and because the first passivation layer is also disposed on the dielectric layer, the first spacing between the first conductive layer and the first passivation layer is large, in other words, the first spacing between the thick metal layer and the first passivation layer is large, so that cracking of the first passivation layer can be better reduced. In other words, this technical solution can reduce cracking of the first passivation layer, and has a better moisture resistance capability.

For a position relationship between the second conductive layer and the first passivation layer, in a possible implementation, a third spacing exists between the second conductive layer and the first passivation layer in the first direction, where the third spacing is less than the first spacing. In this way, a surface that is of the second conductive layer and that faces the first passivation layer is closer to the first passivation layer than the first conductive layer, so that an overlapping area between the second conductive layer and the dielectric layer can be increased. Therefore, the moisture resistance capability of the semiconductor device can be improved.

In another possible implementation, the second conductive layer is in contact with the first passivation layer in the first direction. In this way, the first passivation layer and the second conductive layer may cover all regions of a top surface of the substrate. Therefore, the second conductive layer, the first passivation layer, and the dielectric layer may work together to improve a moisture resistance capability.

In still another possible implementation, a third part of the second conductive layer is stacked between the first passivation layer and the dielectric layer. In this way, there is an overlapping region between the second conductive layer and the first passivation layer. Therefore, the first passivation layer and the second conductive layer may cover more regions on a top surface of the substrate. Therefore, the second conductive layer, the first passivation layer, and the dielectric layer may work together to improve a moisture resistance capability.

Further, the first passivation layer includes at least two passivation sub-layers disposed in a stacked manner, and the third part of the second conductive layer is stacked between at least one passivation sub-layer and the dielectric layer. In this way, there is an overlapping region between the second conductive layer and the at least one passivation sub-layer. Therefore, the first passivation layer and the second conductive layer may cover more regions on the top surface of the substrate. Therefore, the second conductive layer, the first passivation layer, and the dielectric layer may work together to improve a moisture resistance capability.

In addition, a thickness of the first passivation layer is greater than the thickness of the second conductive layer and less than the thickness of the first conductive layer. The overlapping region between the second conductive layer and the dielectric layer is large, in other words, the overlapping region between the thin metal layer and the dielectric layer is large. Because the thickness of the second conductive layer is less than the thickness of the first passivation layer, a contact cross-sectional area between the second conductive layer and the first passivation layer is small. Therefore, large shear stress is not generated, and the first passivation layer does not crack at a position in which the first passivation layer is in contact with the second conductive layer.

In some implementations, the semiconductor device further includes a doped region, a part of the doped region is located between the substrate and the second conductive layer, a part of the doped region is located between the substrate and the dielectric layer, and a projection of the second conductive layer on a first surface is located within a projection range of the doped region on the first surface. In addition, because the overlapping region between the second conductive layer and the dielectric layer is greater than the overlapping region between the first conductive layer and the dielectric layer, a projection of the first conductive layer on the first surface is also located within the projection range of the doped region on the first surface. It may be understood that the semiconductor device further includes a third conductive layer, the third conductive layer is located on a side that is of the substrate and that faces away from the first conductive layer, and electric field distribution may be generated between the third conductive layer and the first conductive layer and between the third conductive layer and the second conductive layer. When the projections of the first conductive layer and the second conductive layer on the first surface are both located within the projection range of the doped region on the first surface, an electric field distribution status is not affected. Therefore, withstand voltage stability of the semiconductor device can be improved.

To further improve the moisture resistance capability of the semiconductor device, the semiconductor device further includes a third passivation layer. The third passivation layer covers at least a part of a surface that is of the first conductive layer and that faces away from the substrate, the second passivation layer, a part of a surface that is of the second conductive layer and that faces away from the substrate, a part of a surface that is of the first passivation layer and that faces the first conductive layer, and a part of a surface that is of the first passivation layer and that faces away from the substrate. A thickness of the third passivation layer is less than the thickness of the second conductive layer. In this way, the third passivation layer can resist moisture. In addition, because the thickness of the third passivation layer is less than the thickness of the second conductive layer, in other words, the thickness of the third passivation layer is less than a thickness of the thin metal layer, the third passivation layer has specific flexibility. Therefore, a case in which the third passivation layer cracks due to heat deformation can be avoided.

In some implementations, the dielectric layer has a second surface facing the substrate, a third surface facing away from the substrate, and an inclined surface connected between the second surface and the third surface and facing the second conductive layer, and a part of the second conductive layer is disposed on the inclined surface. In this way, a contact area between the dielectric layer and the second conductive layer can be increased, and the second conductive layer smoothly transits from a part in which the second conductive layer is in contact with the doped region to a part in which the second conductive layer is in contact with the dielectric layer, thereby avoiding a case in which the second conductive layer cracks on the inclined surface on which the second conductive layer is in contact with the dielectric layer.

Based on this, the dielectric layer has at least two inclined surfaces, a part of a projection of the first conductive layer on the dielectric layer is located between the at least two inclined surfaces, and a projection of an end face that is of the first conductive layer and that faces the first passivation layer on the dielectric layer is located on the inclined surface. The first conductive layer may serve as one electrode of the semiconductor device, and the third conductive layer may serve as another electrode of the semiconductor device. The projection of the end face that is of the first conductive layer and that faces the first passivation layer on the dielectric layer is located on the inclined surface. In this way, the first conductive layer has an appropriate size in the length direction of the semiconductor device. If the end face that is of the first conductive layer and that faces the first passivation layer is located between two inclined surfaces, a size of the first conductive layer in the length direction of the semiconductor device is excessively small. Consequently, a basic function of the first conductive layer may not be implemented. If the projection of the end face that is of the first conductive layer and that faces the first passivation layer on the dielectric layer is located at a periphery of the inclined surface, the size of the first conductive layer in the length direction of the semiconductor device is excessively large, and when the first conductive layer is formed, a curved surface may be formed on the top of the first conductive layer. If the projection of the end face that is of the first conductive layer and that faces the first passivation layer on the dielectric layer is located on the inclined surface, the top surface of the first conductive layer tends to be flat. Therefore, shear stress that occurs during a temperature test of the semiconductor device can be reduced. Further, large deformation and stress generated by each part of the first conductive layer can be reduced, and the stress is transferred to the dielectric layer, the second conductive layer, the doped region, and the like. Consequently, the semiconductor device fails.

According to a second aspect of this application, a chip is provided, including a passive component and the semiconductor device according to any one of the foregoing implementations. The passive component is electrically connected to the semiconductor device. The chip can achieve all effects of the semiconductor device.

According to a third aspect of this application, an electronic device is provided, including a circuit board and the foregoing chip. The circuit board is electrically connected to the chip. The electronic device can implement all effects of the chip.

According to a fourth aspect of this application, a vehicle is provided, including a vehicle body and the foregoing electronic device. The electronic device is fastened inside the vehicle body. The vehicle can implement all effects of the electronic device.

According to a fifth aspect of this application, a manufacturing method of a semiconductor device is further provided. The manufacturing method includes: providing a substrate; forming a dielectric layer on the substrate; forming a first conductive layer; and forming a first passivation layer on the dielectric layer. The first conductive layer and the first passivation layer are disposed on a same side of the substrate. A part of the first conductive layer is stacked on a side that is of the dielectric layer and that faces away from the substrate. A first spacing exists between the first conductive layer and the first passivation layer in a first direction. The first direction is perpendicular to a thickness direction of the semiconductor device, and the first direction may be a length direction or a width direction of the semiconductor device. In other words, the first spacing exists between the first conductive layer and the first passivation layer in the length direction or the width direction of the semiconductor device. In this way, during tests such as a temperature cycle test and temperature shock test of the semiconductor device, the substrate, the first passivation layer, and the first conductive layer may deform differently due to their different CTEs. Because the first spacing exists between the first conductive layer and the first passivation layer, the first passivation layer and the first conductive layer may deform into the first spacing after being heated. Compared with the related technology in which shear stress is generated at a position in which the first passivation layer is in contact with a corner of the first conductive layer because the first conductive layer is in direct contact with the first passivation layer and the first passivation layer covers a top surface and a side surface of the first conductive layer, the technical solution of this application can reduce generation of the shear stress, and reduce a failure, caused by cracking of the first passivation layer, of a semiconductor device, and therefore, can improve reliability of the semiconductor device.

Based on this, after the step of forming the dielectric layer on the substrate, the manufacturing method further includes: forming a second conductive layer on the substrate and the dielectric layer; and the step of forming the first conductive layer includes: forming the first conductive layer on the second conductive layer, where a thickness of the second conductive layer is less than a thickness of the first conductive layer, and an overlapping region between the second conductive layer and the dielectric layer is greater than an overlapping region between the first conductive layer and the dielectric layer. In other words, the first conductive layer is located on a side that is of the second conductive layer and that faces away from the substrate, and the first conductive layer may serve as one electrode of the semiconductor device. The thickness of the second conductive layer is less than the thickness of the first conductive layer. Therefore, the first conductive layer may also be referred to as a thick metal layer, and the second conductive layer may also be referred to as a thin metal layer. The overlapping region between the second conductive layer and the dielectric layer is greater than the overlapping region between the first conductive layer and the dielectric layer. In this way, the overlapping region between the second conductive layer and the dielectric layer is large enough, so that moisture can be better prevented from intruding into the substrate from the second conductive layer and the dielectric layer, that is, the semiconductor device has a better moisture resistance capability. In addition, the overlapping region between the first conductive layer and the dielectric layer is small, and because the first passivation layer is also disposed on the dielectric layer, the first spacing between the first conductive layer and the first passivation layer is large, so that cracking of the first passivation layer can be better reduced. In other words, this technical solution can reduce cracking of the first passivation layer, and has a better moisture resistance capability.

Further, after the step of forming the first conductive layer on the second conductive layer, the manufacturing method further includes: forming a third passivation layer, where the third passivation layer covers at least a part of a surface that is of the first conductive layer and that faces away from the substrate, a part of a surface that is of the first conductive layer and that faces the first passivation layer, a part of a surface that is of the second conductive layer and that faces away from the substrate, a part of a surface that is of the first passivation layer and that faces the first conductive layer, and a part of a surface that is of the first passivation layer and that faces away from the substrate; and a thickness of the third passivation layer is less than the thickness of the second conductive layer. In this way, the third passivation layer can resist moisture. In addition, because the thickness of the third passivation layer is less than the thickness of the second conductive layer, in other words, the thickness of the third passivation layer is less than a thickness of the thin metal layer, the third passivation layer has specific flexibility. Therefore, a case in which the third passivation layer cracks due to heat deformation can be avoided.

### BRIEF DESCRIPTION OF DRAWINGS

To describe technical solutions in embodiments of this application more clearly, the following briefly describes accompanying drawings for describing embodiments of this application. It is clear that the accompanying drawings in the following description show merely some embodiments of this application, and a person of ordinary skill in the art may still derive other accompanying drawings from these accompanying drawings without creative efforts.
FIG. 1 is a diagram of a structure of a semiconductor device in a related technology;
FIG. 2a is a diagram of a structure of a semiconductor device according to a first embodiment of this application;
FIG. 2b is a diagram of a structure of a semiconductor device according to a second embodiment of this application;
FIG. 3 is a cross-sectional view of FIG. 2a along A-A;
FIG. 4 is a diagram of a structure of a semiconductor device according to a third embodiment of this application;
FIG. 5 is a diagram of a structure of a semiconductor device according to a fourth embodiment of this application;
FIG. 6 is a diagram of a structure of a semiconductor device according to a fifth embodiment of this application;
FIG. 7 is a diagram of a structure of a semiconductor device according to a sixth embodiment of this application;
FIG. 8 is a diagram of a structure of a semiconductor device according to a seventh embodiment of this application;
FIG. 9a is a diagram of a structure of a semiconductor device according to an eighth embodiment of this application;
FIG. 9b is a diagram of a structure of a semiconductor device according to a ninth embodiment of this application;
FIG. 9c is a diagram of a structure of a semiconductor device according to a tenth embodiment of this application;
FIG. 10 is a diagram of a structure of a semiconductor device according to an eleventh embodiment of this application;
FIG. 11 is a diagram of a structure of a semiconductor device according to a twelfth embodiment of this application;
FIG. 12 is a diagram of a structure of a semiconductor device according to a thirteenth embodiment of this application;
FIG. 13 is a diagram of a structure of a semiconductor device according to a fourteenth embodiment of this application;
FIG. 14 is a diagram of a structure of a semiconductor device according to a fifteenth embodiment of this application;
FIG. 15 is a schematic flowchart of a manufacturing method of the semiconductor device shown in FIG. 2a;
FIG. 16A to FIG. 16G are a diagram of a specific process of the manufacturing method shown in FIG. 15;
FIG. 17 is a schematic flowchart of a manufacturing method of the semiconductor device shown in FIG. 10; and
FIG. 18A to FIG. 18C are diagrams of a specific process of some steps of the manufacturing method shown in FIG. 17.

Reference numerals: 100-semiconductor device; 102-passivation layer; 10-substrate; 11-first surface; 20-epitaxial layer; 30-doped region; 40-dielectric layer; 41-second surface; 42-third surface; 43-inclined surface; 44-via; 50-first passivation layer; 51-passivation sub-layer; 60-first conductive layer; 70-second conductive layer; 80-third conductive layer; 90-third passivation layer; 110-protective layer; 111-groove; 120-oxide layer; 130-polysilicon layer; and 140-second passivation layer.

### DESCRIPTION OF EMBODIMENTS

The following clearly and completely describes technical solutions in embodiments of this application with reference to accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The term "and/or" in this specification describes only an association relationship between associated objects and indicates that three relationships may exist. For example, A and/or B may indicate the following three cases: Only A exists, both A and B exist, and only B exists, where A and B may be singular or plural. The character "/" generally indicates an "or" relationship between the associated objects. "At least one (item)" means one or more, and "a plurality of" means two or more. The expression "at least one of the following items (pieces)" or a similar expression means any combination of these items, including a single item (piece) or any combination of a plurality of items (pieces). For example, at least one of a, b, or c may indicate a, b, c, a and b, a and c, b and c, or a, b, and c, where a, b, and c may be singular or plural.

In the specification and claims in embodiments of this application, the terms "first", "second", and the like are used for distinguishing between different objects, but are not used for describing a particular order of the objects. For example, a first target object, a second target object, and the like are used for distinguishing between different target objects, but are not used for describing a specific order of the target objects.

The terms such as "connection", "connected", and the like are used for indicating interworking or mutual interaction between different components, and may include a direct connection or an indirect connection via another component. In addition, the terms "include", "have", and any variant thereof are intended to cover non-exclusive inclusion, for example, include a series of steps or units. A method, system, product, or device is not necessarily limited to those steps or units expressly listed, but may include other steps or units not expressly listed or inherent to such a process, method, product, or device. "On", "below", "left", "right", and the like are used only relative to the orientation of the components in the accompanying drawings. These directional terms are relative concepts, are used for relative descriptions and clarifications, and may change accordingly as positions at which the components in the accompanying drawings are placed change.

In embodiments of this application, the word like "example" or "for example" is used to represent giving an example, an illustration, or a description. Any embodiment or design scheme described as an "example" or "for example" in embodiments of this application should not be explained as being more preferred or having more advantages than another embodiment or design scheme. To be precise, use of the word like "example" or "for example" is intended to present a relative concept in a specific manner.

In descriptions of embodiments of this application, unless otherwise stated, "plurality of" means two or more than two. For example, a plurality of processing units mean two or more processing units, and a plurality of systems mean two or more systems.

An electronic device and a vehicle body are usually disposed in a vehicle, and the electronic device is fastened inside the vehicle body. The electronic device may be, for example, a PFC rectifier, an inverter, an on-board electric drive MCU, and an OBC. The electronic device usually includes a chip and a circuit board, and the chip is electrically connected to the circuit board. A semiconductor device and a passive component are disposed in the chip, and the semiconductor device is electrically connected to the passive component. The semiconductor device may be, for example, a transistor, and the transistor may be specifically a diode, a triode, or the like. For example, the diode may be specifically a Schottky barrier diode (Schottky Barrier Diode, SBD), and the triode may be specifically a metal-oxide semiconductor field-effect transistor (Metal-Oxide Semiconductor Field-Effect Transistor, MOSFET). The passive component may be, for example, a capacitor or a resistor.

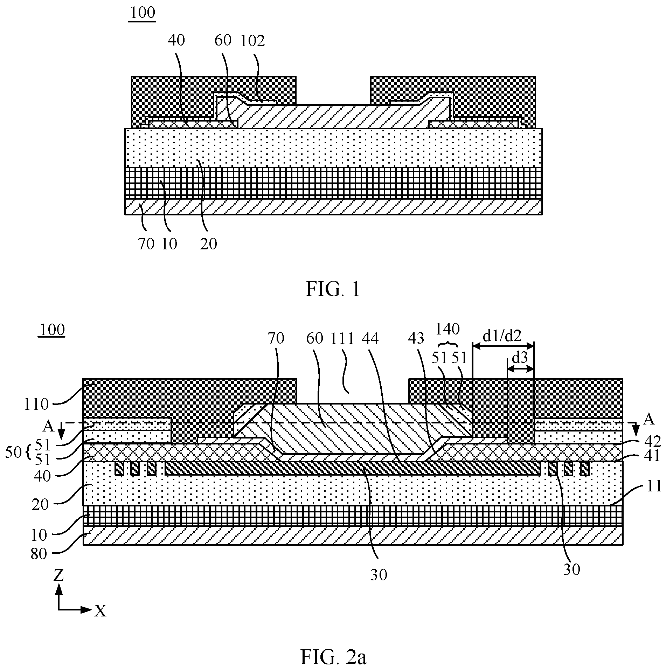

A structure of the semiconductor device may be a structure shown in FIG. 1. A semiconductor device 100 may include a substrate 10, an epitaxial layer 20, a dielectric layer 40, a first conductive layer 60, a second conductive layer 70, a passivation layer 102, and the like. A material of the substrate 10 may include SiC. SiC is a wide bandgap semiconductor material. Compared with a Si material, SiC has features such as high critical breakdown field strength, high thermal conductivity, and a high intrinsic operating temperature. Therefore, the semiconductor device 100 has advantages of a high operating junction temperature and low switching losses, thereby facilitating high-frequency and lightweight implementation of an electronic device.

As shown in FIG. 1, the epitaxial layer 20 is disposed on the substrate 10, and the dielectric layer 40 is disposed on the epitaxial layer 20. A part of the first conductive layer 60 is disposed on the epitaxial layer 20, and the other part of the first conductive layer 60 is stacked on the dielectric layer 40. The second conductive layer 70 is disposed on a side that is of the substrate 10 and that faces away from the first conductive layer 60. The first conductive layer 60 and the second conductive layer 70 may be two electrodes of the semiconductor device 100.

To resist an external impurity and moisture intrusion, the first conductive layer 60 and the dielectric layer 40 are generally covered with the passivation layer 102. A material of the passivation layer 102 is an inorganic material like silicon dioxide or silicon nitride.

A CTE value of SiC is large, while a CTE value of a material like silicon dioxide or silicon nitride is small, in other words, a CTE value of the substrate 10 is large, while a CTE value of the passivation layer 102 is small. In addition, a difference of CTE values between the two is large. After packaging of the semiconductor device 100 is completed, reliability tests such as a temperature cycle test and a temperature shock test need to be performed. In this test process, shear stress is usually generated due to mismatch of the CTE value of the substrate 10 and the CTE value of the passivation layer 102. The shear stress is generated at a position in which the passivation layer 102 is in contact with a corner of the first conductive layer 60 because the first conductive layer 60 is in direct contact with the passivation layer 102 and the passivation layer 102 covers a top surface and a side surface of the first conductive layer 60. Because the material of the passivation layer 102 is rigid, the shear stress causes a crack inside the passivation layer 102, resulting in cracking of the passivation layer 102 and a failure of the semiconductor device 100.

Based on this, as shown in FIG. 2a, an embodiment of this application provides a semiconductor device 100. The semiconductor device 100 may be a diode. The semiconductor device 100 may include a substrate 10, an epitaxial layer 20, doped regions 30, a dielectric layer 40, a first passivation layer 50, a first conductive layer 60, a second conductive layer 70, a third conductive layer 80, and a protective layer 110.

For ease of better description of the semiconductor device 100 in this embodiment, three directions may be defined herein, which are respectively a first direction (X direction), a second direction (Y direction), and a third direction (Z direction). The X direction is a length direction of the semiconductor device 100, the Y direction is a width direction of the semiconductor device 100, and the Z direction is a thickness direction of the semiconductor device 100. In addition, every two of the X direction, the Y direction, and the Z direction are perpendicular to each other.

The substrate 10 may be a doped substrate, a doping type of the substrate 10 may be a first type, and the first type is a P type or an N type. As shown in FIG. 2a, for ease of description, a first surface 11 may be defined on the substrate 10, and the first surface 11 may be a top surface of the substrate 10. It may be understood that the "top surface" and a "bottom surface" are surfaces determined by using the third conductive layer 80 as the bottom of the semiconductor device 100. A "top surface" of any part may be a surface that is of the part and that faces away from the third conductive layer 80, and a "bottom surface" of any part may be a surface that is of the part and that faces the third conductive layer 80.

As shown in FIG. 2a, the epitaxial layer 20 is disposed on the first surface 11, a size of the epitaxial layer 20 in an X direction is the same as a size of the substrate 10 in the X direction, and a size of the epitaxial layer 20 in a Y direction may also be the same as a size of the substrate 10 in the Y direction. The epitaxial layer 20 may be a doped epitaxial layer, and a doping type of the epitaxial layer 20 may be the same as the doping type of the substrate 10. For example, when the doping type of the substrate 10 is the first type, the doping type of the epitaxial layer 20 may also be the first type.

As shown in FIG. 2a, the third conductive layer 80 may be disposed on the bottom surface of the substrate 10, to be specific, the third conductive layer 80 and the epitaxial layer 20 are respectively disposed on two opposite sides of the substrate 10. A size of the third conductive layer 80 in the X direction may be the same as the size of the substrate 10 in the X direction, and a size of the third conductive layer 80 in the Y direction may also be the same as the size of the substrate 10 in the Y direction.

A material of a third conductive layer 80 may include metal. Specifically, the material of the third conductive layer 80 may be pure metal or a metal compound. For example, the material of the third conductive layer 80 may include aluminum, copper, nickel, titanium, silver, gold, and a related metal compound, and these metal materials have a good conductivity characteristic.

As shown in FIG. 2a, the doped regions 30 are located on a side that is of the epitaxial layer 20 and that faces away from the substrate 10, that is, the doped regions 30 are located on a top surface of the epitaxial layer 20. There may be a plurality of doped regions 30. A size of a doped region 30 located in the middle is larger in the X direction, and sizes of doped regions 30 located on two sides of the doped region 30 are smaller in the X direction. It may be understood that the following doped region 30 is the doped region 30 located in the middle.

As shown in FIG. 2a, the two sides of the doped region 30 are respectively spaced apart from two sides of the epitaxial layer 20 by specific distances. A doping type of the doped region 30 may be different from the doping type of the epitaxial layer 20. For example, the doping type of the doped region 30 may be a second type, and the second type may be an N type or a P type. It may be understood that the first type is different from the second type. For example, when the first type is the P type, the second type is the N type; or when the first type is the N type, the second type is the P type.

As shown in FIG. 2a, the dielectric layer 40 is disposed on a side that is of the epitaxial layer 20 and the doped region 30 and that faces away from the substrate 10, and a via 44 is disposed in the middle of the dielectric layer 40. The via 44 is located opposite to the doped region 30, to expose a part of a top surface of the doped region 30. In other words, the dielectric layer 40 covers the top surface of the epitaxial layer 20 and the part of the top surface of the doped region 30.

As shown in FIG. 2a, the dielectric layer 40 has a second surface 41 facing the substrate 10, a third surface 42 facing away from the substrate 10, and an inclined surface 43 connected between the second surface 41 and the third surface 42.

As shown in FIG. 2a, the first passivation layer 50 is disposed on a side that is of the dielectric layer 40 and that faces away from the substrate 10. The first passivation layer 50 includes one or more passivation sub-layers 51. In an example, as shown in FIG. 2a, the first passivation layer 50 includes two passivation sub-layers 51. The two passivation sub-layers 51 are stacked on the side that is of the dielectric layer 40 and that faces away from the substrate 10. Each of the two passivation sub-layers 51 covers a part of a region on the dielectric layer 40. For example, a size of the passivation sub-layer 51 in the X direction is less than a size of the dielectric layer 40 in the X direction. In this embodiment, the two passivation sub-layers 51 have a same size in the X direction. In another embodiment, the two passivation sub-layers 51 may have different sizes in the X direction.

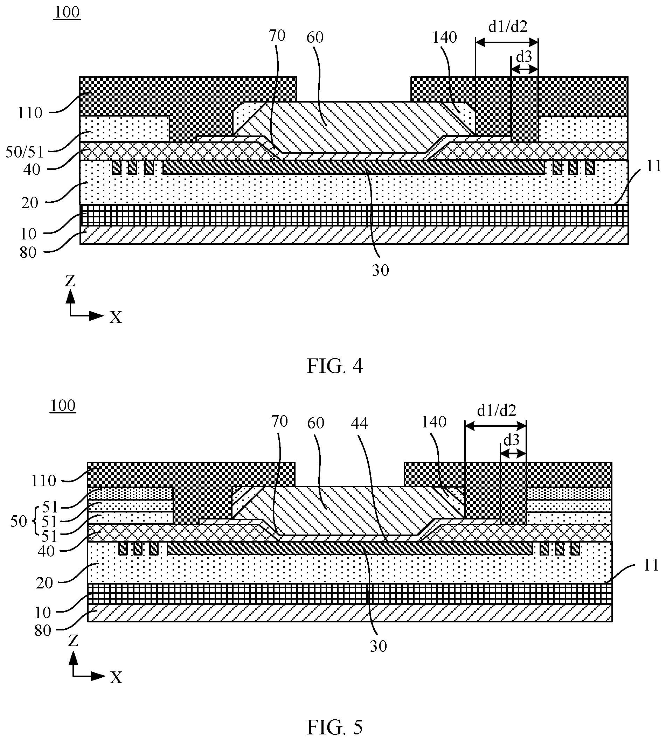

In another example, as shown in FIG. 4, the first passivation layer 50 includes one passivation sub-layer 51. In still another example, as shown in FIG. 5, the first passivation layer 50 includes three passivation sub-layers 51. It may be understood that, in another embodiment, there may alternatively be four, five, or more passivation sub-layers 51 in the first passivation layer 50.

A thickness of the passivation sub-layer 51 may be greater than 0.1 um. For example, the thickness of the passivation sub-layer 51 is 0.2 um, 0.5 um, or 0.7 um. When the first passivation layer 50 includes a plurality of passivation sub-layers 51, thicknesses of the passivation sub-layers 51 may be the same or may be different.

In addition, a material of the passivation sub-layer 51 may include a common dielectric material like silicon dioxide, silicon nitride, or semi-insulating polycrystalline silicon, or an inorganic dielectric material including materials such as nitrogen, carbon, oxygen, phosphorus, and boron. In addition, when the first passivation layer 50 includes the plurality of passivation sub-layers 51, materials of the passivation sub-layers 51 may be the same or different.

As shown in FIG. 2a, a part of the second conductive layer 70 is disposed in the via 44 and is in contact with the doped region 30, and a remaining part of the second conductive layer 70 is disposed on the dielectric layer 40. In addition, the second conductive layer 70 covers a part of a region on the dielectric layer 40. In other words, a part of the doped region 30 is located between the substrate 10 and the second conductive layer 70, and a part of the doped region 30 is located between the substrate 10 and the dielectric layer 40.

As shown in FIG. 2a, a part of the second conductive layer 70 is disposed on the inclined surface 43. In this way, a contact area between the dielectric layer 40 and the second conductive layer 70 can be increased, and the second conductive layer 70 smoothly transits from a part in which the second conductive layer 70 is in contact with the doped region 30 to a part in which the second conductive layer 70 is in contact with the dielectric layer 40, thereby avoiding a case in which the second conductive layer 70 cracks on the inclined surface 43 on which the second conductive layer 70 is in contact with the dielectric layer 40.

A material of the second conductive layer 70 may include metal. Specifically, the material of the second conductive layer 70 may be pure metal or a metal compound. For example, the material of the second conductive layer 70 may include aluminum, copper, nickel, titanium, silver, gold, and a related metal compound, and these metal materials have a good conductivity characteristic.

As shown in FIG. 2a, the first conductive layer 60 is located on a side that is of the second conductive layer 70 and that faces away from the substrate 10, and covers a part of a region of the second conductive layer 70. In other words, a size of the first conductive layer 60 in the X direction is less than a size of the second conductive layer 70 in the X direction. In addition, a part of the first conductive layer 60 covers a part that is of the second conductive layer 70 and that is located on the doped region 30, and a part of the first conductive layer 60 covers a part that is of the second conductive layer 70 and that is located on the dielectric layer 40. In other words, a first part of the second conductive layer 70 is located between the first conductive layer 60 and the doped region 30, and a second part of the second conductive layer 70 is located between the first conductive layer 60 and the dielectric layer 40.

As shown in FIG. 2a, in a possible implementation, a part of the first conductive layer 60 is located in the via 44, and a projection of an end face that is of the first conductive layer 60 and that faces the first passivation layer 50 on the dielectric layer 40 is located at a periphery of the inclined surface 43.

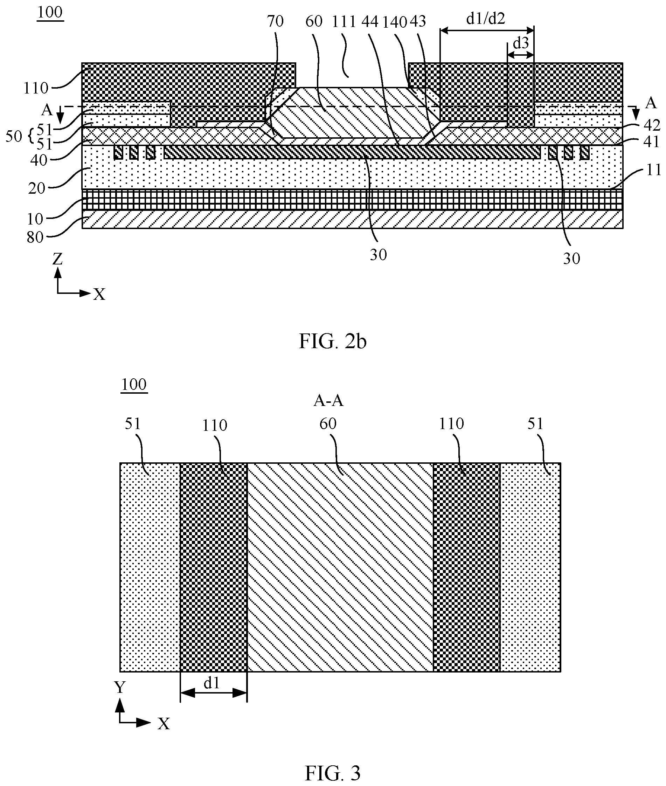

In another possible implementation, as shown in FIG. 2b, a part of the first conductive layer 60 is located in the via 44, and a projection of an end face that is of the first conductive layer 60 and that faces the first passivation layer 50 on the dielectric layer 40 is located on the inclined surface 43. In this way, the size of the first conductive layer 60 in the X direction is moderate. If the end face that is of the first conductive layer 60 and that faces the first passivation layer 50 is located between two inclined surfaces 43, the size of the first conductive layer 60 in the X direction is excessively small. Consequently, a basic function of the first conductive layer 60 may not be implemented. If the projection of the end face that is of the first conductive layer 60 and that faces the first passivation layer 50 on the dielectric layer 40 is located on the inclined surface 43, a top surface of the first conductive layer 60 tends to be flat. Therefore, the shear stress that occurs during a temperature test of the semiconductor device 100 can be reduced. Further, large deformation and stress generated by each part of the first conductive layer 60 can be reduced, and the stress is transferred to the dielectric layer 40, the second conductive layer 70, the doped region 30, and the epitaxial layer 20. Consequently, the semiconductor device 100 fails.

As shown in FIG. 2a, parts of the first passivation layer 50 and the first conductive layer 60 are both disposed on the side that is of the dielectric layer 40 and that faces away from the substrate 10. In addition, as shown in FIG. 3, a first spacing d1 exists between the first conductive layer 60 and the first passivation layer 50 in the X direction, and a size of the first conductive layer 60 in the Y direction is the same as a size of the first passivation layer 50 in the Y direction. In other words, the first spacing d1 exists between the first conductive layer 60 and the first passivation layer 50 in the length direction of the semiconductor device 100, and a size of the first conductive layer 60 in the width direction of the semiconductor device 100 is the same as a size of the first passivation layer 50 in the width direction. In another embodiment, the first spacing d1 exists between the first conductive layer 60 and the first passivation layer 50 in the Y direction, and the size of the first conductive layer 60 in the X direction is the same as a size of the first passivation layer 50 in the X direction.

It may be understood that the first spacing d1 may be a minimum spacing between the first conductive layer 60 and the first passivation layer 50. For example, when the first passivation layer 50 includes one passivation sub-layer 51, the first spacing d1 may be a spacing between the first conductive layer 60 and the passivation sub-layer 51; or when the first passivation layer 50 includes the plurality of passivation sub-layers 51, and sizes of the plurality of passivation sub-layers 51 in the X direction are not completely the same, the first spacing d1 may be a minimum value of spacings between the first conductive layer 60 and the passivation sub-layers 51.

During the tests such as a temperature cycle test and a temperature shock test of the semiconductor device 100, the substrate 10, the first passivation layer 50, and the first conductive layer 60 may deform differently due to their different CTEs. Because the first spacing d1 exists between the first conductive layer 60 and the first passivation layer 50, the first passivation layer 50 and the first conductive layer 60 may deform into the first spacing d1 after being heated. Compared with the related technology shown in FIG. 1 in which the shear stress is generated at the position in which the passivation layer 102 is in contact with the corner of the first conductive layer 60 because the first conductive layer 60 is in direct contact with the passivation layer 102 and the passivation layer 102 covers the top surface and the side surface of the first conductive layer 60, the technical solution of this embodiment can reduce generation of the shear stress, and reduce a failure, caused by cracking of the first passivation layer 50, of a semiconductor device 100, and therefore, can improve reliability of the semiconductor device 100.

In addition, as shown in FIG. 2a, the first conductive layer 60 is located on the side that is of the second conductive layer 70 and that faces away from the substrate 10, the first conductive layer 60 may serve as one electrode of the semiconductor device 100, and the third conductive layer 80 may serve as another electrode of the semiconductor device 100. A thickness of the second conductive layer 70 is less than a thickness of the first conductive layer 60. For example, the thickness of the second conductive layer 70 may be less than 1 um. For example, the thickness of the second conductive layer 70 may be 0.2 um or 0.4 um. The thickness of the first conductive layer 60 may be greater than 1 um. For example, the thickness of the first conductive layer 60 may be 2 um or 4 um. Therefore, the first conductive layer 60 may also be referred to as a thick metal layer, and the second conductive layer 70 may also be referred to as a thin metal layer.

As shown in FIG. 2a, an overlapping region between the second conductive layer 70 and the dielectric layer 40 is greater than an overlapping region between the first conductive layer 60 and the dielectric layer 40. In this way, the overlapping region between the second conductive layer 70 and the dielectric layer 40 is larger, in other words, an overlapping region between the thin metal layer and the dielectric layer 40 is larger, so that moisture can be better prevented from intruding into the substrate 10 from the second conductive layer 70 and the dielectric layer 40, that is, the semiconductor device 100 has a better moisture resistance capability. In addition, the overlapping region between the first conductive layer 60 and the dielectric layer 40 is smaller, and because the first passivation layer 50 is also disposed on the dielectric layer 40, the first spacing d1 between the first conductive layer 60 and the first passivation layer 50 is large, in other words, the first spacing d1 between the thick metal layer and the first passivation layer 50 is large, so that cracking of the first passivation layer 50 can be better reduced. In other words, this technical solution can reduce cracking of the first passivation layer 50, and has a better moisture resistance capability.

As shown in FIG. 2a, a projection of the second conductive layer 70 on the first surface 11 is located within a projection range of the doped region 30 on the first surface 11. In addition, because the overlapping region between the second conductive layer 70 and the dielectric layer 40 is greater than the overlapping region between the first conductive layer 60 and the dielectric layer 40, a projection of the first conductive layer 60 on the first surface 11 is also located within the projection range of the doped region 30 on the first surface 11. Electric field distribution may be generated between the third conductive layer 80 and the first conductive layer 60 and between the third conductive layer 80 and the second conductive layer 70. When the projections of the first conductive layer 60 and the second conductive layer 70 on the first surface 11 are both located within the projection range of the doped region 30 on the first surface 11, an electric field distribution status is not affected. Therefore, withstand voltage stability of the semiconductor device 100 can be improved.

It may be understood that the overlapping region between the second conductive layer 70 and the dielectric layer 40 may be an overlapping region between a projection region of the second conductive layer 70 on the first surface 11 and a projection region of the dielectric layer 40 on the first surface 11. Similarly, the overlapping region between the first conductive layer 60 and the dielectric layer 40 may be an overlapping region between a projection region of the first conductive layer 60 on the first surface 11 and the projection region of the dielectric layer 40 on the first surface 11.

Further, as shown in FIG. 2a, a third spacing d3 exists between the second conductive layer 70 and the first passivation layer 50 in the X direction, and the third spacing d3 is less than the first spacing d1. In addition, a difference between the first spacing d1 and the third spacing d3 is greater than 0.5 um. For example, the difference between the first spacing d1 and the third spacing d3 may be 1 um, 3 um, or 5 um. It may be understood that the third spacing d3 may be a minimum spacing between the second conductive layer 70 and the first passivation layer 50. For example, when the first passivation layer 50 includes one passivation sub-layer 51, the third spacing d3 may be a spacing between the second conductive layer 70 and the passivation sub-layer 51; or when the first passivation layer 50 includes the plurality of passivation sub-layers 51, and the sizes of the plurality of passivation sub-layers 51 in the X direction are not completely the same, the third spacing d3 may be a minimum value of spacings between the second conductive layer 70 and the passivation sub-layers 51. In this way, a surface that is of the second conductive layer 70 and that faces the first passivation layer 50 is closer to the first passivation layer 50 than the first conductive layer 60, so that an overlapping area between the second conductive layer 70 and the dielectric layer 40 can be increased. Therefore, the moisture resistance capability of the semiconductor device 100 can be improved.

In addition, as shown in FIG. 2a, a thickness of the first passivation layer 50 is greater than the thickness of the second conductive layer 70 and less than the thickness of the first conductive layer 60. The overlapping region between the second conductive layer 70 and the dielectric layer 40 is large, in other words, the overlapping region between the thin metal layer and the dielectric layer 40 is large. Because the thickness of the second conductive layer 70 is less than the thickness of the first passivation layer 50, a contact cross-sectional area between the second conductive layer 70 and the first passivation layer 50 is small. Therefore, large shear stress is not generated, and the first passivation layer 50 does not crack at a position in which the first passivation layer 50 is in contact with the second conductive layer 70.

A material of the first conductive layer 60 may include metal. Specifically, the material of the first conductive layer 60 may be pure metal or a metal compound. For example, the material of the first conductive layer 60 may include aluminum, copper, nickel, titanium, silver, gold, and a related metal compound, and these metal materials have a good conductivity characteristic.

As shown in FIG. 2a, the semiconductor device 100 may further include a second passivation layer 140. The second passivation layer 140 covers a side surface of the first conductive layer 60. A second spacing d2 exists between the second passivation layer 140 and the first passivation layer 50 in the X direction. The second spacing d2 is the same as or has a small difference from the first spacing d1, and the second spacing d2 is greater than the third spacing d3 between the second conductive layer 70 and the first passivation layer 50. In a process of manufacturing the semiconductor device 100, the dielectric layer 40, the first conductive layer 60, and the second conductive layer 70 may be first formed on the substrate 10, then passivation layers are formed on the first conductive layer 60, the second conductive layer 70, and the dielectric layer 40 in a deposition manner, and a passivation layer located on the top surface of the first conductive layer 60 and a passivation layer within a specific distance from the side surface of the first conductive layer 60 are etched away, to form the first passivation layer 50. Because the side surface of the first conductive layer 60 is an inclined surface, a size of the passivation layer covering the side surface of the first conductive layer 60 is large in the Z direction, and the passivation layer covering the side surface of the first conductive layer 60 cannot be completely etched away within same duration in which the passivation layer covering the top surface of the first conductive layer 60 can be etched, a remaining passivation layer that is left on the side surface of the first conductive layer 60 and that is obtained after etching is the second passivation layer 140. Therefore, the etching duration can be shortened, and costs can be reduced. Because the second passivation layer 140 covers only the side surface of the first conductive layer 60, and does not cover both the top surface and the side surface of the first conductive layer 60 and a corner therebetween, generation of shear stress in the second passivation layer 140 can be reduced.

It may be understood that the second passivation layer 140 and the first passivation layer 50 are formed by using a same process step. Therefore, a quantity of layers and a layer thickness of the second passivation layer 140 may be respectively the same as a quantity of layers and a layer thickness of the first passivation layer 50. For example, as shown in FIG. 2a, the second passivation layer 140 may alternatively include two passivation sub-layers 51.

In addition, in this embodiment, a surface that is of the second passivation layer 140 and that faces away from the substrate 10 is flush with a surface that is of the first conductive layer 60 and that faces away from the substrate 10. In another embodiment, the surface that is of the second passivation layer 140 and that faces away from the substrate 10 may be lower than the surface that is of the first conductive layer 60 and that faces away from the substrate 10.

As shown in FIG. 2a, a groove 111 is disposed on the protective layer 110, and the groove 111 is located on the first conductive layer 60, to expose a part of a region on the top surface of the first conductive layer 60. A region that is on the first conductive layer 60 and that is not covered by the protective layer 110 may be a feature region. Exposure of the feature region facilitates soldering and packaging with another component or electronic device. Therefore, as shown in FIG. 2a, the protective layer 110 may cover a part of a surface of the first conductive layer 60, a top surface of the second passivation layer 140, a surface that is of the second passivation layer 140 and that faces the first passivation layer 50, a part that is of the second conductive layer 70 and that exceeds the first conductive layer 60, a part of a region of the dielectric layer 40, and a surface that is of the first passivation layer 50 and that faces away from the substrate 10. That is, a part of the protective layer 110 may be located in the second spacing d2 between the second passivation layer 140 and the first passivation layer 50. A material of the protective layer 110 may include polyimide (Polyimide, PI). The material has high flexibility and elasticity, and therefore extrusion generated by a plastic packaging material in a packaging process can be alleviated, and diffusion of a particle in the plastic packaging material can be prevented, thereby protecting the first conductive layer 60, the second passivation layer 140, the second conductive layer 70, the dielectric layer 40, and the first passivation layer 50. In addition, when manufacturing of the semiconductor device 100 is completed and a test is performed, because a part of the protective layer 110 is located in the first spacing d1 between the first conductive layer 60 and the first passivation layer 50, the protective layer 110 is subject to shear stress. Because the protective layer 110 has high flexibility and elasticity, the protective layer 110 can buffer the shear stress, thereby reducing the failure, caused by cracking of the first passivation layer 50, of the semiconductor device 100.

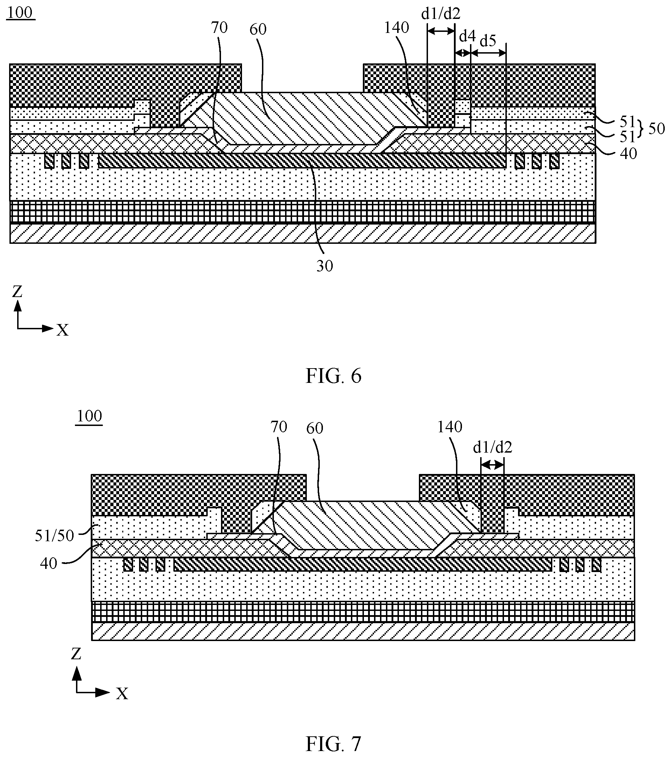

In another embodiment of this application, as shown in FIG. 6, a difference between the embodiment shown in FIG. 6 and the embodiment shown in FIG. 2a lies in a position relationship between the second conductive layer 70 and the first passivation layer 50. Specifically, in this embodiment, as shown in FIG. 6, a third part of the second conductive layer 70 is stacked between the first passivation layer 50 and the dielectric layer 40. In this way, there is an overlapping region between the second conductive layer 70 and the first passivation layer 50. For example, a fourth spacing d4 exists between the surface that is of the second conductive layer 70 and that faces the first passivation layer 50 and a surface that is of the first passivation layer 50 and that faces the first conductive layer 60. The fourth spacing d4 may be greater than 0.1 um, for example, 0.5 um or 1 um. In addition, the first spacing d1 between the first conductive layer 60 and the first passivation layer 50 may also be greater than 0.1 um, for example, 0.5 um or 1 um. A fifth spacing d5 exists between the surface that is of the second conductive layer 70 and that faces the first passivation layer 50 and a side of the doped region 30 in the X direction. The fifth spacing d5 may also be greater than 0.1 um, for example, 0.5 um or 1 um. In this way, the first passivation layer 50 and the second conductive layer 70 may cover all regions of the first surface 11 of the substrate 10. Therefore, the second conductive layer 70, the first passivation layer 50, and the dielectric layer 40 may work together to improve a moisture resistance capability.

In this embodiment, there may alternatively be one or more passivation sub-layers 51 in the first passivation layer 50. In an example, as shown in FIG. 6, the first passivation layer 50 includes two passivation sub-layers 51. The third part of the second conductive layer 70 is located between at least one passivation sub-layer 51 and the dielectric layer 40. For example, as shown in FIG. 6, the third part of the second conductive layer 70 is located between the two passivation sub-layers 51 and the dielectric layer 40. In this way, there is an overlapping region between the second conductive layer 70 and the two passivation sub-layers 51, so that moisture resistance performance of the semiconductor device 100 can be further improved.

In another example, as shown in FIG. 7, the first passivation layer 50 includes one passivation sub-layer 51. In this case, the third part of the second conductive layer 70 is located between the passivation sub-layer 51 and the dielectric layer 40.

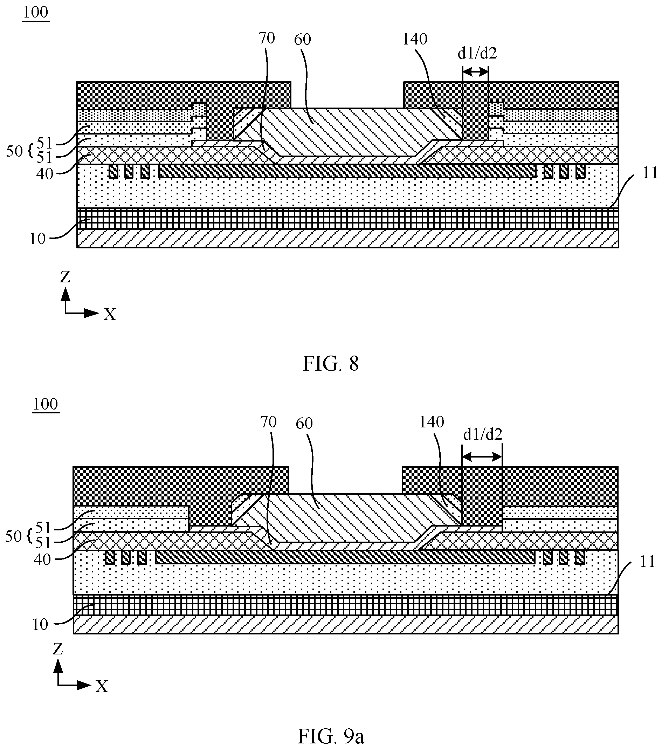

In still another example, as shown in FIG. 8, the first passivation layer 50 includes three passivation sub-layers 51. In this case, the third part of the second conductive layer 70 is located between the three passivation sub-layers 51 and the dielectric layer 40.

In another embodiment of this application, as shown in FIG. 9a, a difference between the embodiment shown in FIG. 9a and the embodiment shown in FIG. 2a lies in a position relationship between the second conductive layer 70 and the first passivation layer 50. As shown in FIG. 9a, the second conductive layer 70 is in contact with the first passivation layer 50 in the X direction. In this way, the first passivation layer 50 and the second conductive layer 70 may cover all regions of the first surface 11 of the substrate 10. Therefore, the second conductive layer 70, the first passivation layer 50, and the dielectric layer 40 may work together to improve a moisture resistance capability.

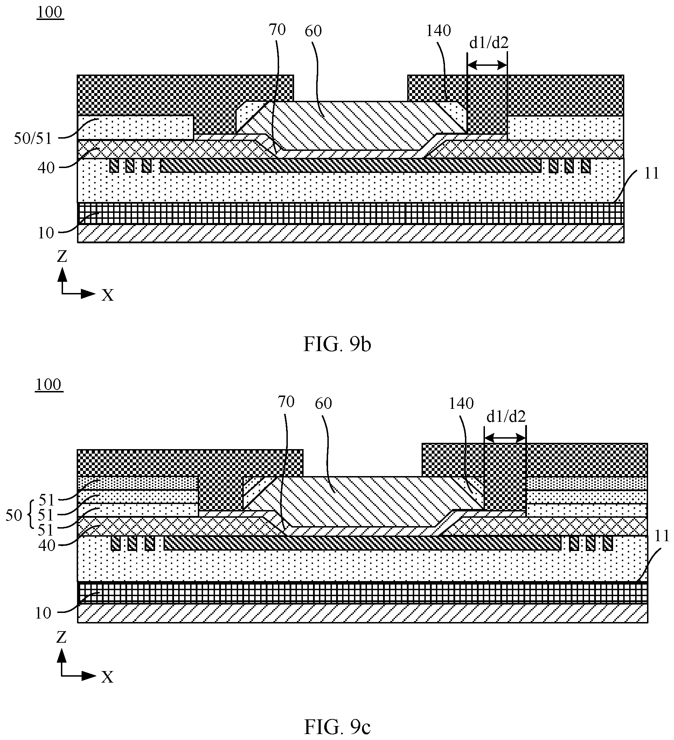

In another example, as shown in FIG. 9b, the first passivation layer 50 includes one passivation sub-layer 51. In this case, the second conductive layer 70 is in contact with the passivation sub-layer 51.

In still another example, as shown in FIG. 9c, the first passivation layer 50 includes three passivation sub-layers 51. In this case, the second conductive layer 70 is in contact with a bottommost passivation sub-layer 51 in the three passivation sub-layers 51.

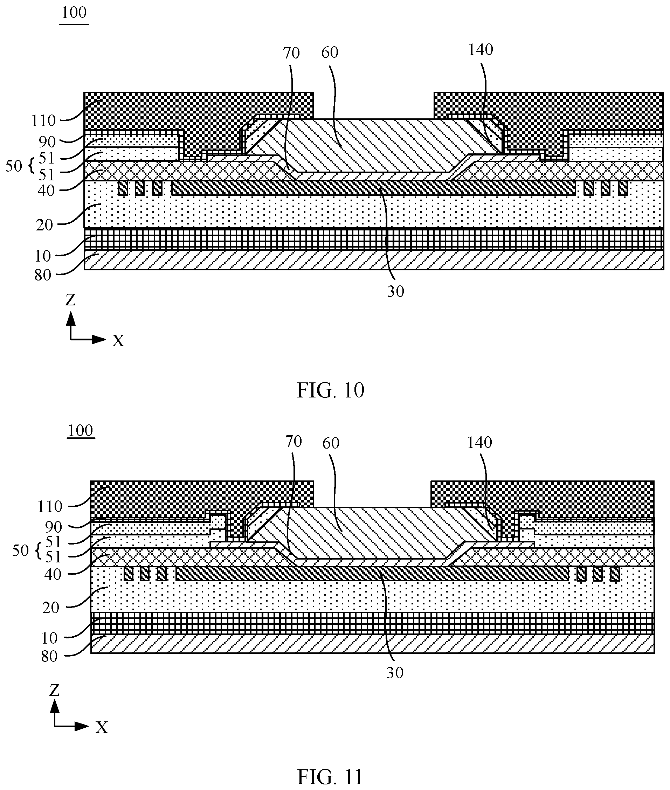

In another embodiment of this application, as shown in FIG. 10, a difference between the embodiment shown in FIG. 10 and the embodiment shown in FIG. 2a lies in that a third passivation layer 90 is added in this embodiment based on the embodiment shown in FIG. 2a. Specifically, as shown in FIG. 10, the third passivation layer 90 is located on a side that is of the protective layer 110 and that faces the substrate 10. In addition, the third passivation layer 90 covers at least a part of a surface that is of the first conductive layer 60 and that faces away from the substrate 10, the surface that is of the second passivation layer 140 and that faces away from the substrate 10, the surface that is of the second passivation layer 140 and that faces the first passivation layer 50, a part of a surface that is of the second conductive layer 70 and that faces away from the substrate 10, the surface that is of the second conductive layer 70 and that faces the first passivation layer 50, a surface, located between the first passivation layer 50 and the second conductive layer 70, that is of the dielectric layer 40 and that faces away from the substrate 10, a surface that is of the first passivation layer 50 and that faces the first conductive layer 60, and the surface that is of the first passivation layer 50 and that faces away from the substrate 10. The part of the region on the top surface of the first conductive layer 60 is a feature region, and the third passivation layer 90 does not cover the part of the region, thereby facilitating soldering and packaging between the first conductive layer 60 and another component or electronic device. In this way, the third passivation layer 90 can resist moisture. In addition, a thickness of the third passivation layer 90 is less than the thickness of the second conductive layer 70, in other words, the thickness of the third passivation layer 90 is less than a thickness of the thin metal layer. For example, the thickness of the third passivation layer 90 is less than 1 um, for example, 0.1 um or 0.2 um. Therefore, the third passivation layer 90 has specific flexibility. In this way, a case in which the third passivation layer 90 cracks due to heat deformation can be avoided.

A material of the third passivation layer 90 may be similar to or the same as a material attribute of the first passivation layer 50. For example, the material of the third passivation layer 90 may include a common dielectric material like silicon dioxide, silicon nitride, or semi-insulating polycrystalline silicon, or an inorganic dielectric material including nitrogen, carbon, oxygen, phosphorus, boron, and the like.

In another embodiment of this application, as shown in FIG. 11, a difference between the embodiment shown in FIG. 11 and the embodiment shown in FIG. 6 lies in that a third passivation layer 90 is added in this embodiment based on the embodiment shown in FIG. 6. Specifically, as shown in FIG. 11, the third passivation layer 90 is located on a side that is of the protective layer 110 and that faces the substrate 10. In addition, the third passivation layer 90 covers a part of a surface that is of the first conductive layer 60 and that faces away from the substrate 10, the surface that is of the second passivation layer 140 and that faces away from the substrate 10, the surface that is of the second passivation layer 140 and that faces the first passivation layer 50, a surface, located between the first conductive layer 60 and the first passivation layer 50, that is of the second conductive layer 70 and that faces away from the substrate 10, a surface that is of the first passivation layer 50 and that faces the first conductive layer 60, and the surface that is of the first passivation layer 50 and that faces away from the substrate 10.

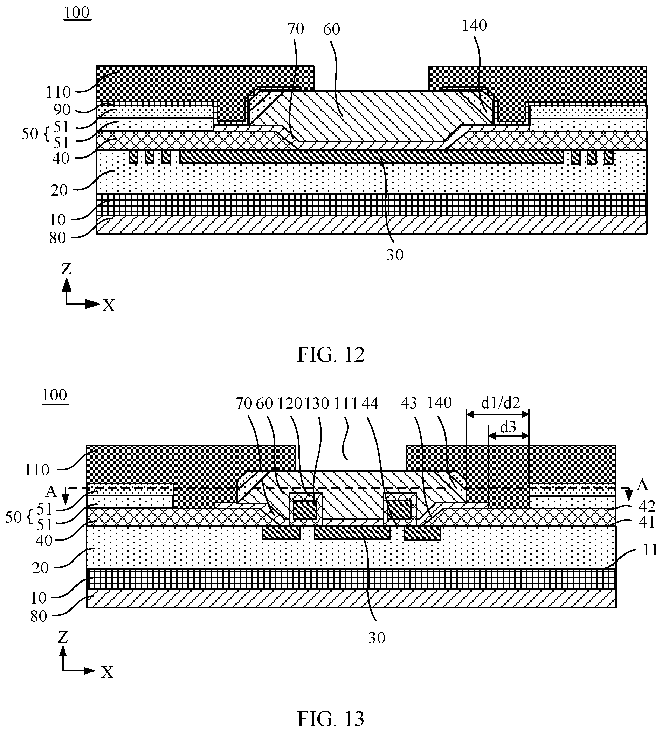

In another embodiment of this application, as shown in FIG. 12, a difference between the embodiment shown in FIG. 12 and the embodiment shown in FIG. 9a lies in that a third passivation layer 90 is added in this embodiment based on the embodiment shown in FIG. 9a. As shown in FIG. 12, the third passivation layer 90 is located on a side that is of the protective layer 110 and that faces the substrate 10. In addition, the third passivation layer 90 covers a part of a surface that is of the first conductive layer 60 and that faces away from the substrate 10, the surface that is of the second passivation layer 140 and that faces away from the substrate 10, a part of a surface that is of the second passivation layer 140 and that faces the first passivation layer 50, a part of a surface that is of the second conductive layer 70 and that faces away from the substrate 10, the surface that is of the second conductive layer 70 and that faces the first passivation layer 50, a surface, located between the first passivation layer 50 and the second conductive layer 70, that is of the dielectric layer 40 and that faces away from the substrate 10, a surface that is of the first passivation layer 50 and that faces the first conductive layer 60, and the surface that is of the first passivation layer 50 and that faces away from the substrate 10.

In another embodiment of this application, as shown in FIG. 13, a difference between the embodiment shown in FIG. 13 and the embodiment shown in FIG. 2a lies in that an oxide layer 120 and a polysilicon layer 130 are added in this embodiment based on the semiconductor device 100 shown in FIG. 2a, and sizes of overlapping regions between the first conductive layer 60 and the doped region 30 and between the second conductive layer 70 and the doped region 30 are different. Specifically, in this embodiment, the semiconductor device 100 may be a triode. The first conductive layer 60 may be a source electrode of the triode, the third conductive layer 80 may be a drain electrode of the triode, and the polysilicon layer 130 may be a gate electrode of the triode.

As shown in FIG. 13, both the oxide layer 120 and the polysilicon layer 130 are located inside the first conductive layer 60 and the second conductive layer 70, and the oxide layer 120 wraps the polysilicon layer 130. There may be a plurality of doped regions 30, and a projection of the polysilicon layer 130 on the substrate 10 overlaps a projection of at least one doped region 30 on the substrate 10.

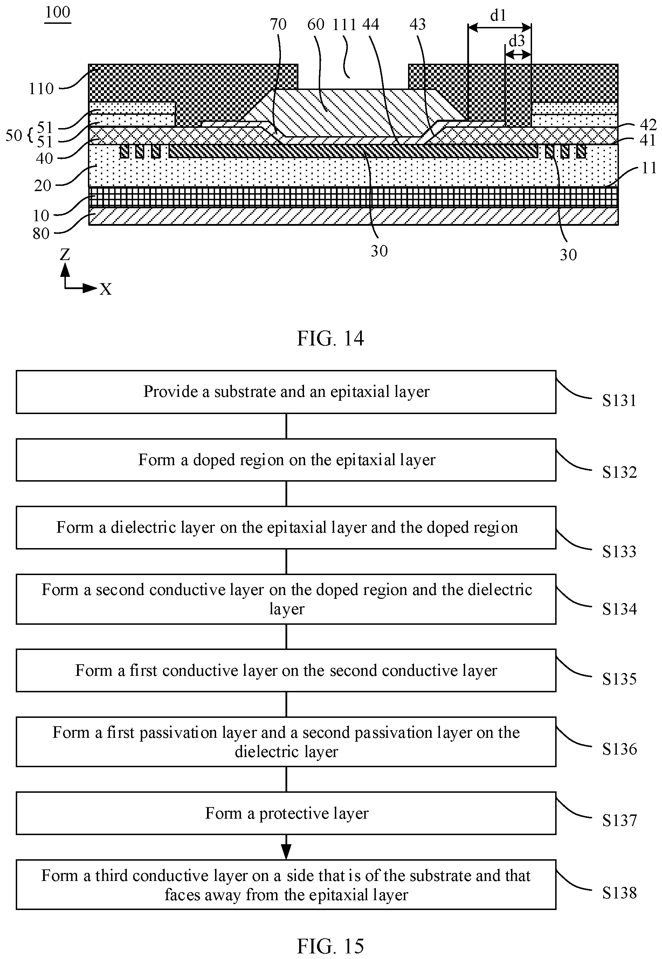

In another embodiment of this application, as shown in FIG. 14, a difference between the embodiment shown in FIG. 14 and the embodiment shown in FIG. 2a lies in that the second passivation layer 140 is removed from the embodiment shown in FIG. 2a in this embodiment. The protective layer 110 may cover a part of a surface that is of the first conductive layer 60 and that faces away from the substrate 10, a surface that is of the first conductive layer 60 and that faces the first passivation layer 50, a part of a surface, located between the first conductive layer 60 and the first passivation layer 50, that is of the second conductive layer 70 and that faces away from the substrate 10, the surface that is of the second conductive layer 70 and that faces the first passivation layer 50, a part of a surface, located between the second conductive layer 70 and the first passivation layer 50, that is of the dielectric layer 40 and that faces away from the substrate 10, a surface that is of the first passivation layer 50 and that faces the first conductive layer 60, and the surface that is of the first passivation layer 50 and that faces away from the substrate 10.

It may be understood that, in another embodiment, the second passivation layer 140 may alternatively be removed based on any one of the embodiments shown in FIG. 4 to FIG. 13.

An embodiment of this application further provides a manufacturing method of a semiconductor device 100. The manufacturing method may be applied to the semiconductor device 100 shown in FIG. 2a. As shown in FIG. 15, the manufacturing method includes the following steps.

S131: Provide a substrate and an epitaxial layer.

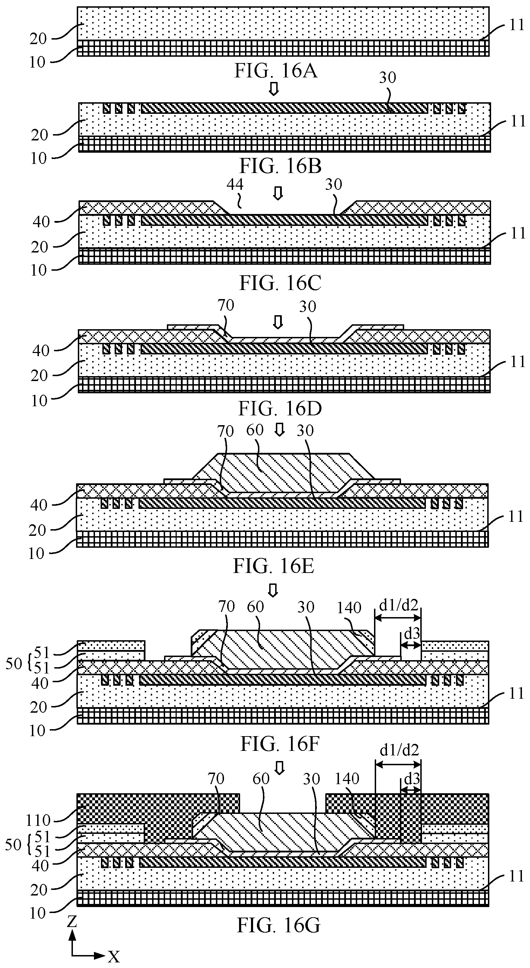

As shown in FIG. 16A, a substrate 10 has a first surface 11, and an epitaxial layer 20 is disposed on the first surface 11. The substrate 10 may be a doped substrate, and the epitaxial layer 20 may be a doped epitaxial layer 20. In addition, doping types of the substrate 10 and the epitaxial layer 20 may be the same. For example, the doping types of the substrate 10 and the epitaxial layer 20 may both be a first type.

S132: Form a doped region on the epitaxial layer.

Silicon carbide semiconductor doping may be performed on a top surface of the epitaxial layer 20, to form a doped region 30 shown in FIG. 16B. A size of the doped region 30 in an X direction is less than a size of the epitaxial layer 20 in the X direction, and the doped region 30 is located in the middle of the epitaxial layer 20.

S133: Form a dielectric layer on the epitaxial layer and the doped region.

As shown in FIG. 16C, in a manufacturing process, a dielectric layer 40 may be formed in a manner of deposition first and then etching, and a via 44 is disposed on the dielectric layer 40. A part of the dielectric layer 40 is located on the epitaxial layer 20, and a part of the dielectric layer 40 is located on the doped region 30. In other words, the dielectric layer 40 covers a part of a top surface of the epitaxial layer 20 and a part of a top surface of the doped region 30. The doped region 30 corresponds to the via 44 of the dielectric layer 40, and is exposed from the via 44.

S134: Form a second conductive layer on the doped region and the dielectric layer.

As shown in FIG. 16D, the second conductive layer 70 may be formed on a part of a region that is located between dielectric layers 40 and that is on a top surface of the doped region 30, and on top surfaces of the dielectric layer 40 that are located on two sides of the region.

S135: Form a first conductive layer on the second conductive layer.

As shown in FIG. 16E, a first conductive layer 60 is formed on a top surface of the second conductive layer 70, and the first conductive layer 60 covers a part of a region on a top surface of the second conductive layer 70. A thickness of the second conductive layer 70 is less than a thickness of the first conductive layer 60. The first conductive layer 60 and the dielectric layer 40 have an overlapping region.

S136: Form a first passivation layer and a second passivation layer on the dielectric layer.

Passivation layers may be formed on the first conductive layer 60, the second conductive layer 70, and the dielectric layer 40, and a passivation layer located on a top surface of the first conductive layer 60 and a passivation layer within a specific distance from a side surface of the first conductive layer 60 are etched away, to form a first passivation layer 50 and a second passivation layer 140 shown in FIG. 16F. In this embodiment, there are two first passivation layers 50, the two first passivation layers 50 are disposed opposite to each other and spaced apart, and each first passivation layer 50 includes two passivation sub-layers 51. Therefore, two passivation sub-layers 51 close to the dielectric layer 40 may be formed earlier than two passivation sub-layers 51 facing away from the dielectric layer 40.

In addition, in this embodiment, there is no overlapping region between the second conductive layer 70 and the first passivation layer 50, and a third spacing d3 exists between the second conductive layer 70 and the first passivation layer 50. In addition, a first spacing d1 exists between the first conductive layer 60 and the first passivation layer 50 in the X direction. The second passivation layer 140 covers the side surface of the first conductive layer 60, and a second spacing d2 exists between the second passivation layer 140 and the first passivation layer 50 in the X direction. In addition, the second spacing d2 is greater than the third spacing d3 between the second conductive layer 70 and the first passivation layer 50. Therefore, the first passivation layer 50 and the first conductive layer 60 may deform into the first spacing d1 after being heated. Compared with the related technology shown in FIG. 1 in which the shear stress is generated at the position in which the passivation layer 102 is in contact with the corner of the first conductive layer 60 because the first conductive layer 60 is in direct contact with the passivation layer 102 and the passivation layer 102 covers the top surface and the side surface of the first conductive layer 60, the technical solution of this embodiment can reduce generation of the shear stress, and reduce a failure, caused by cracking of the first passivation layer 50, of the semiconductor device 100, and therefore, can improve reliability of the semiconductor device 100.

It may be understood that, in this embodiment, in the process of manufacturing the semiconductor device 100, the second conductive layer 70 and the first conductive layer 60 are formed earlier than the first passivation layer 50. In another embodiment, the first passivation layer 50 may alternatively be formed earlier than the second conductive layer 70 and the first conductive layer 60.

S137: Form a protective layer.

The protective layer is formed on a top surface of the semiconductor device 100 obtained in step S136, and a hole is drilled in the middle of the protective layer, to obtain a protective layer 110 shown in FIG. 16G. In addition, disposing of the drilled hole may enable a part of a surface of the first conductive layer 60 to be exposed, thereby facilitating soldering between the first conductive layer 60 and another component.

S138: Form a third conductive layer on a side that is of the substrate and that faces away from the epitaxial layer.

A third conductive layer 80 is formed on a side that is of the substrate 10 and that faces away from the epitaxial layer 20, in other words, the third conductive layer 80 is formed on a bottom surface of the substrate 10, to obtain the semiconductor device 100 shown in FIG. 2a.

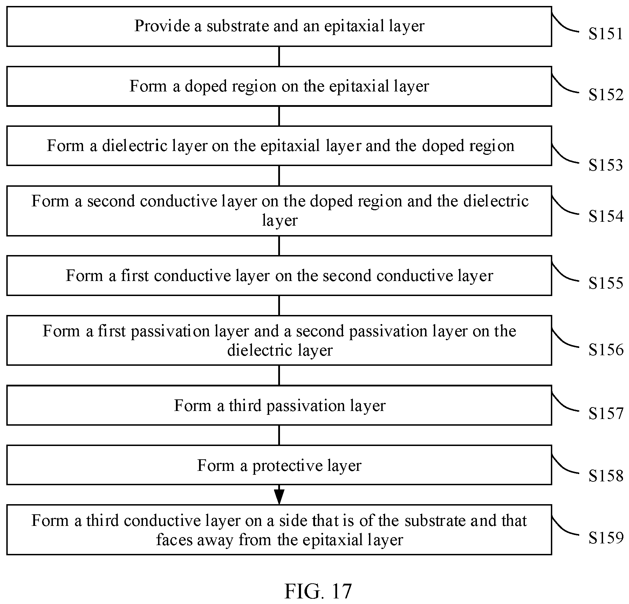

An embodiment of this application further provides a manufacturing method of a semiconductor device 100. The manufacturing method may be applied to the semiconductor device 100 shown in FIG. 10. As shown in FIG. 17, the manufacturing method includes the following steps.

S151: Provide a substrate and an epitaxial layer.

Refer to step S131 shown in FIG. 15 and FIG. 16A.

S152: Form a doped region on the epitaxial layer.

Refer to step S132 shown in FIG. 15 and FIG. 16B.

S153: Form a dielectric layer on the epitaxial layer and the doped region.

Refer to step S133 shown in FIG. 15 and FIG. 16C.

S154: Form a second conductive layer on the doped region and the dielectric layer.

Refer to step S134 shown in FIG. 15 and FIG. 16D.

S155: Form a first conductive layer on the second conductive layer.

Refer to step S135 shown in FIG. 15 and FIG. 16E.

S156: Form a first passivation layer and a second passivation layer on the dielectric layer.

Refer to step S136 shown in FIG. 15 and FIG. 16F.

S157: Form a third passivation layer.

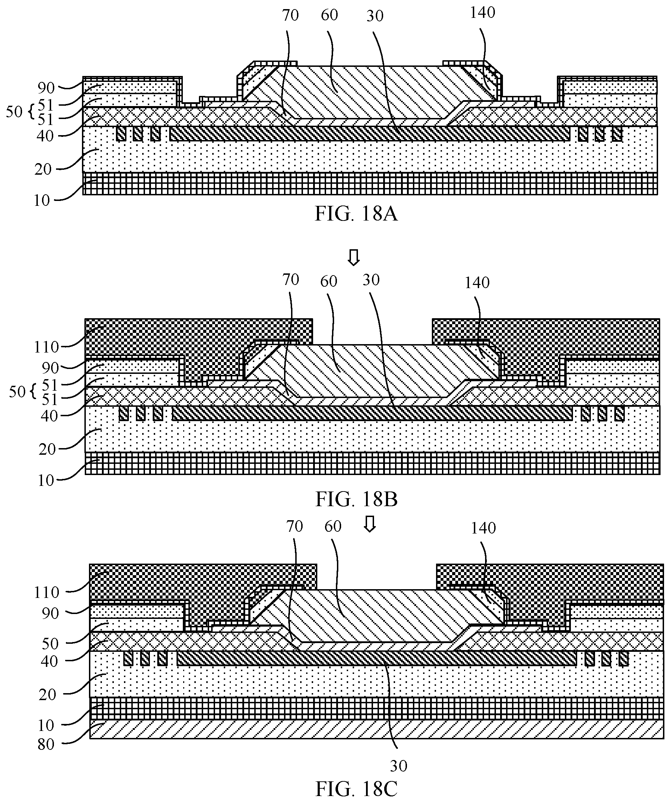

As shown in FIG. 18A, a third passivation layer 90 is formed on a top surface of the semiconductor device 100 obtained in step S156, and the third passivation layer 90 may be obtained in a manner of first deposition and then etching. The third passivation layer 90 covers a part of a surface that is of the first conductive layer 60 and that faces away from a substrate 10, a surface that is of the second passivation layer 140 and that faces away from the substrate 10, a part of a surface that is of the second passivation layer 140 and that faces a first passivation layer 50, a part of a surface that is of the second conductive layer 70 and that faces away from the substrate 10, a surface that is of the second conductive layer 70 and that faces the first passivation layer 50, a surface, located between the first passivation layer 50 and the second conductive layer 70, that is of a dielectric layer 40 and that faces away from the substrate 10, a surface that is of the first passivation layer 50 and that faces the first conductive layer 60, and a surface that is of the first passivation layer 50 and that faces away from the substrate 10. In addition, a thickness of the third passivation layer 90 is less than a thickness of the second conductive layer 70. In this way, the third passivation layer 90 can resist moisture. In addition, the thickness of the third passivation layer 90 is less than the thickness of the second conductive layer 70, in other words, the thickness of the third passivation layer 90 is less than a thickness of a thin metal layer. For example, the thickness of the third passivation layer 90 is less than 1 um, for example, 0.1 um or 0.2 um. Therefore, the third passivation layer 90 has specific flexibility. In this way, a case in which the third passivation layer 90 cracks due to heat deformation can be avoided.

S158: Form a protective layer.

As shown in FIG. 18A, a protective layer 110 is formed on the top surface of the semiconductor device 100 obtained in step S136, and a hole is drilled in the middle of the protective layer 110, to obtain the protective layer 110 shown in FIG. 18A. In addition, disposing of the drilled hole may enable a part of a surface of the first conductive layer 60 to be exposed, thereby facilitating soldering between the first conductive layer 60 and another component.

S159: Form a third conductive layer on a side that is of the substrate and that faces away from the epitaxial layer.

As shown in FIG. 18C, a third conductive layer 80 is formed on a side that is of the substrate 10 and that faces away from an epitaxial layer 20, in other words, the third conductive layer 80 is formed on a bottom surface of the substrate 10, to obtain the semiconductor device 100 shown in FIG. 10.

The foregoing describes embodiments of this application with reference to the accompanying drawings. However, this application is not limited to the foregoing specific implementations. The foregoing specific implementations are merely non-limiting examples. In light of the teachings of this application, a person of ordinary skill in the art may further make many modifications without departing from the purposes of this application and the protection scope of the claims, and all the modifications shall fall within the protection of this application.

## Claims

1. A semiconductor device, comprising:
a substrate;
a dielectric layer, wherein the dielectric layer is disposed on the substrate;
a first passivation layer, wherein the first passivation layer is disposed on a side that is of the dielectric layer and that faces away from the substrate; and
a first conductive layer, wherein the first conductive layer and the first passivation layer are disposed on a same side of the substrate, and a part of the first conductive layer is stacked on the side that is of the dielectric layer and that faces away from the substrate; and a first spacing exists between the first conductive layer and the first passivation layer in a first direction, wherein the first direction is perpendicular to a thickness direction of the semiconductor device.

2. The semiconductor device according to claim 1, wherein the semiconductor device further comprises a second passivation layer, the second passivation layer covers a side surface of the first conductive layer, and a second spacing exists between the second passivation layer and the first passivation layer in the first direction.

3. The semiconductor device according to claim 2, wherein the semiconductor device further comprises a protective layer, a part of the protective layer covers the first conductive layer, the second passivation layer, and the first passivation layer, and a part of the protective layer is located in the second spacing.

4. The semiconductor device according to claim 2 or 3, wherein the semiconductor device further comprises a second conductive layer, the second conductive layer is located between the first conductive layer and the substrate, a second part of the second conductive layer is located between the first conductive layer and the dielectric layer, a thickness of the second conductive layer is less than a thickness of the first conductive layer, and an overlapping region between the second conductive layer and the dielectric layer is greater than an overlapping region between the first conductive layer and the dielectric layer.

5. The semiconductor device according to claim 4, wherein a third spacing exists between the second conductive layer and the first passivation layer in the first direction, wherein the third spacing is less than the first spacing.

6. The semiconductor device according to claim 4, wherein the second conductive layer is in contact with the first passivation layer in the first direction.

7. The semiconductor device according to claim 4, wherein a third part of the second conductive layer is stacked between the first passivation layer and the dielectric layer.

8. The semiconductor device according to claim 7, wherein the first passivation layer comprises at least two passivation sub-layers disposed in a stacked manner, and the third part of the second conductive layer is stacked between at least one passivation sub-layer and the dielectric layer.

9. The semiconductor device according to any one of claims 4 to 7, wherein the semiconductor device further comprises a doped region, a part of the doped region is located between the substrate and the second conductive layer, a part of the doped region is located between the substrate and the dielectric layer, and a projection of the second conductive layer on the substrate is located within a projection range of the doped region on the substrate.

10. The semiconductor device according to any one of claims 4 to 9, wherein the semiconductor device further comprises a third passivation layer, the third passivation layer covers at least a part of a surface that is of the first conductive layer and that faces away from the substrate, the second passivation layer, a part of a surface that is of the second conductive layer and that faces away from the substrate, a part of a surface that is of the first passivation layer and that faces the first conductive layer, and a part of a surface that is of the first passivation layer and that faces away from the substrate; and a thickness of the third passivation layer is less than a thickness of the second conductive layer.

11. The semiconductor device according to any one of claims 4 to 10, wherein the dielectric layer has a second surface facing the substrate, a third surface facing away from the substrate, and an inclined surface connected between the second surface and the third surface and facing the second conductive layer, and a part of the second conductive layer is disposed on the inclined surface.

12. The semiconductor device according to claim 11, wherein the dielectric layer has at least two inclined surfaces, a partial projection of the first conductive layer on the dielectric layer is located between the at least two inclined surfaces, and a projection of an end face that is of the first conductive layer and that faces the first passivation layer on the dielectric layer is located on the inclined surface.

13. A chip, comprising a passive component and the semiconductor device according to any one of claims 1 to 12, wherein the passive component is electrically connected to the semiconductor device.

14. An electronic device, comprising a circuit board and the chip according to claim 13, wherein the circuit board is electrically connected to the chip.

15. A vehicle, comprising a vehicle body and the electronic device according to claim 14, wherein the electronic device is fastened inside the vehicle body.

16. A manufacturing method of a semiconductor device, wherein the manufacturing method comprises:
providing a substrate;
forming a dielectric layer on the substrate;
forming a first conductive layer; and
forming a first passivation layer on the dielectric layer, wherein the first conductive layer and the first passivation layer are disposed on a same side of the substrate, and a part of the first conductive layer is stacked on a side that is of the dielectric layer and that faces away from the substrate; and a first spacing exists between the first conductive layer and the first passivation layer in a first direction, wherein the first direction is perpendicular to a thickness direction of the semiconductor device.

17. The manufacturing method according to claim 16, wherein after the step of forming the dielectric layer on the substrate, the manufacturing method further comprises:
forming a second conductive layer on the substrate and the dielectric layer; and
the step of forming the first conductive layer comprises:
forming the first conductive layer on the second conductive layer, wherein a thickness of the second conductive layer is less than a thickness of the first conductive layer, and an overlapping region between the second conductive layer and the dielectric layer is greater than an overlapping region between the first conductive layer and the dielectric layer.

18. The manufacturing method according to claim 17, wherein after the step of forming the first conductive layer on the second conductive layer, the manufacturing method further comprises:
forming a third passivation layer, wherein the third passivation layer covers at least a part of a surface that is of the first conductive layer and that faces away from the substrate, a part of a surface that is of the first conductive layer and that faces the first passivation layer, a part of a surface that is of the second conductive layer and that faces away from the substrate, a part of a surface that is of the first passivation layer and that faces the first conductive layer, and a part of a surface that is of the first passivation layer and that faces away from the substrate; and a thickness of the third passivation layer is less than the thickness of the second conductive layer.
